# EUROPEAN PATENT SPECIFICATION

(11) **EP 4 610 873 B1**
(45) Date of publication and mention of the grant of the patent: **02.12.2026**
(21) Application number: 24305324.6
(22) Date of filing: 01.03.2024
(51) Int. Cl.: G06F 30/20, G06F 30/367, G06N 10/00

(54) **COMPUTER-IMPLEMENTED METHOD FOR DETERMINING PHYSICAL PARAMETERS OF A SUPERCONDUCTING QUANTUM CIRCUIT**
COMPUTERIMPLEMENTIERTES VERFAHREN ZUR BESTIMMUNG PHYSIKALISCHER PARAMETER EINES SUPRALEITENDEN QUANTENSCHALTKREISES
PROCÉDÉ MIS EN OEUVRE PAR ORDINATEUR POUR DÉTERMINER DES PARAMÈTRES PHYSIQUES D'UN CIRCUIT QUANTIQUE SUPRACONDUCTEUR

(43) Date of publication of application: 03.09.2025
(73) Proprietor: Alice & Bob, 75015 Paris (FR)
(72) Inventor: LESCANNE, Raphaël, 75015 Paris (FR); JEZOUIN, Sébastien, 75015 Paris (FR); HALLÉN, Mattis, 75015 Paris (FR)
(74) Representative: Atout PI Laplace

(56) References cited:
- GLOCK HANS-WALTER ET AL: "CSC - A Procedure for Coupled S-Parameter Calculations", 2 March 2002 (2002-03-02), pages 1 - 4, XP093190547, Retrieved from the Internet <URL:https://ieeexplore.ieee.org/stampPDF/getPDF.jsp?tp=&arnumber=996300&ref=aHR0cHM6Ly9pZWVleHBsb3JlLmllZWUub3JnL2RvY3VtZW50Lzk5NjMwMA==> [retrieved on 20240729]
- ROTHEMUND K. ET AL: "Eigenmode Calculation in Long and Complex RF-Structures Using the Coupled S-Parameter Calculation Technique", 30 November 2000 (2000-11-30), pages 1 - 6, XP093190553, Retrieved from the Internet <URL:https://flash.desy.de/sites2009/site_vuvfel/content/e403/e1644/e1446/e1448/infoboxContent1684/TESLA2000-33.pdf> [retrieved on 20240729]
- YVONNE Y GAO ET AL: "A practical guide for building superconducting quantum devices", ARXIV.ORG, CORNELL UNIVERSITY LIBRARY, 201 OLIN LIBRARY CORNELL UNIVERSITY ITHACA, NY 14853, 14 September 2021 (2021-09-14), XP091047321

## Description

The invention concerns a method for determining physical parameters of a superconducting quantum circuit based on its circuit blueprint.

Quantum computing is a burgeoning field in which pre-fabrication determination of the physical parameters of superconducting circuits is a crucial part of the design process. In conventional circuit design, this is achieved by simulating a circuit in view of detecting potential errors early in the process in order to avoid expensive reworking of the circuit prototype.

In the quantum computing context, the goal is similarly to understand whether a proposed chip design has the desired frequency responses for components therein, but also to enable the experimentalists which fabricate the physical prototype to know the correct pulse frequencies to send to those components to achieve the desired frequency responses and/or resonances for qubit stabilization and manipulation.

Most prior art methods use large finite-element Maxwell solvers, which are computationally expensive and inherently limited in the number of eigenmodes which can be simulated. This is an issue for larger complex circuits.

Below are listed some of the most relevant prior art methods.

Ansys HFSS (https://www.ansys.com/products/electronics/ansys-hfss) is a state of the art finite element Maxwell solver. It is computationally extremely expensive, and only provides a limited maximum number of eigenmodes.

IBM Qiskit Metal simulation program, as described in the article by Minev et al. "Circuit quantum electrodynamics (cQED) with modular quasi-lumped models" arXiv.org:2103.10344 [quant-ph] decomposes superconducting circuits, presimulates element models, and diagonalizes assembled model to get eigenmodes. However, this tool relies on capacitance/inductance matrices, which significantly limits its usage.

Scattering parameter simulator tool SAX within GDSFactory (https://flaport.github.io/sax/) models elements with scattering, connects in circuits, simulate aggregated transmission and reflection in circuit. However, this simulator is not tailored for quantum superconducting circuits and it does not compute eigenmodes.

Finally, the article by Glock et al. "CSC - A procedure for coupled S-parameter calculations", IEEE Transactions on Magnetics, Volume: 38, Issue: 2, March 2002 (hereinafter "the CSC article"), describes decomposing large RF structure problems into a structure of smaller ones based on frequency dependent scattering parameters. However, this simulator cannot be efficiently used with superconducting quantum circuit as it teaches computing the eigenvalues of the problem along the real axis with a brute force approach.

The invention aims at improving the situation. To this end, the Applicant proposes a computer-implemented method computer-implemented method for determining physical parameters of a superconducting quantum circuit comprising the following operations:
a) obtaining a superconducting quantum circuit blueprint comprising a representation of a physical arrangement of a superconducting metal and a dielectric substrate for forming a 2D or 3D superconducting quantum circuit and a frequency range in the microwave domain,
b) tiling said superconducting quantum circuit blueprint into elements having at least one port for receiving or emitting electromagnetic microwaves, each of said elements being defined as a closed region of said representation and being such that it showcases no self-resonance frequency in said frequency range, and such that each element comprises a port connected to a port of another element, the elements thereby defining a closed network and a corresponding network matrix based on the connections between the ports of respective elements,
c) obtaining scattering parameters for each of said elements, said scattering parameters defining the relationships between all output radiation and all input radiation for each port of each of said elements in the form of a scattering matrix in which the scattering parameters are expressed as a complex function of frequency that is holomorphic in a complex domain,
d) determining mode frequencies and corresponding mode amplitude vectors for a superconducting quantum circuit fabricated using the superconducting quantum circuit blueprint by using a holomorphic non-linear eigenvalue solver to solve the equation (*FS*(*ω*) *- I*)*a* = 0 where F is the network matrix, S is a block diagonal matrix comprising all of the scattering matrices of operation c), I is the identity matrix, *ω* is a complex frequency in the domain where matrix S is holomorphic, and a is a mode amplitude vector.

This method is advantageous because it leverages a tiling which yields holomorphic scattering functions of the elements which allows to parallelize the determination of the eigenmodes.

In various embodiments, the method may present one or more of the following features:
- operation d) comprises
   d1) performing a closed contour integration around the complex frequency domain based on said frequency range for estimating the number of eigenvalues of the equation (*FS*(*ω*) *- I*)*a* = 0 using a rank test,
   d2) performing a second closed contour integration around the complex frequency domain based on said frequency range and the number of eigenvalues of operation d1) to identify a corresponding number of pairs each comprising a mode frequency *ωᵢ* and an amplitude vector *aᵢ* which form an eigenvalue and an eigenvector for the matrix *FS*(*ω*)*a*;
- operation d1) comprises:
   d11) calculating the contour integration around the complex frequency domain based on said frequency range of (*FS*(*ω*) *- I*)⁻¹,
   d12) compute the singular value decomposition of the result of operation d11) and obtain a product *X* _{*} *Sigma* _{*} *Y** where X and Y* are matrices and Sigma is a diagonal matrix,
   d13) determining the number of eigenvalues by ordering the values of matrix Sigma and determining the rank of the last diagonal value which is greater than 1/1000 of the diagonal value having the highest value;
- operation d2) comprises:
   d21) calculating the contour integration around the complex frequency domain based on said frequency range of *ω*(*FS*(*ω*) *- I*)*a*⁻¹,
   d22) multiplying the result of operation d21) on the left by the conjugate transpose of matrix X reduced to a number of columns equal to the number of eigenvalues of operation d1), and on the right by the inverse of matrix Sigma multiplied by matrix Y* reduced to a number of columns equal to the number of eigenvalues of operation d1),
   d23) diagonalize the result of operation d22) to obtain a decomposition M _{*} *Lambda* _{*} *M*⁻¹ where Lambda is a diagonal matrix containing the mode frequencies for the superconducting quantum circuit blueprint;
- operation b) comprises identifying elements in said superconducting quantum circuit blueprint for which scattering parameters are known and tiling based on these elements;
- operation c) comprises simulating the high-frequency behavior of an element to determine its scattering parameters;
- the method further comprises:
   e) calculating the stored energy for each element;
- the method further comprises:
   f) determining all zero point fluctuations for the Josephson junctions of said superconducting quantum circuit by:
   f1) normalizing the mode amplitude vectors by the square of the energy of operation e),
   f2) determining the zero point fluctuations for each mode in each Josephson junction using the formula (28), and
   f3) determining the Chi matrix based on the energy of each Josephson junction and on the results of operation f2); and
- the method further comprises:
   g) calculating the dissipated energy for each element.

The invention also concerns a computer program comprising instructions which, when executed by processing circuitry, causes the processing circuitry to carry out the above method, a carrier containing such a computer program wherein the carrier comprises one of an electronic signals, optical signal, radio signal or computer readable storage medium, and a computer program product comprising a non-transitory computer readable medium having stored thereon such a computer program.

Other features and advantages of the invention will readily appear in the following description of the drawings, which show exemplary embodiments of the invention and on which:
- Figure 1 shows a general diagram of a computer device for carrying out a method according to an embodiment,
- Figure 2 shows a generic view of a computer program used in the embodiment of Figure 1,
- Figure 3 shows a generic view of a superconducting quantum circuit blueprint on the left, and a portion of the corresponding manufactured superconducting quantum circuit on the right,
- Figure 4 shows a generic view of a part of the superconducting quantum circuit blueprint shown on Figure 3 on the left, and a closed circuit made of elements corresponding to a tiling of the same on the right,
- Figure 5 shows a block diagram of a method according to an embodiment,
- Figure 6 shows an example of an operation of Figure 5,
- Figure 7 shows an example of another operation of Figure 5,
- Figures 8 to 10 show example of elements formed during a tiling operation, and
- Figure 11 shows a plot used in an operation of Figure 6.

The drawings and the following description are comprised for the most part of positive and well-defined features. As a result, they are not only useful in understanding the invention, but they can also be used to contribute to its definition, should the need arise.

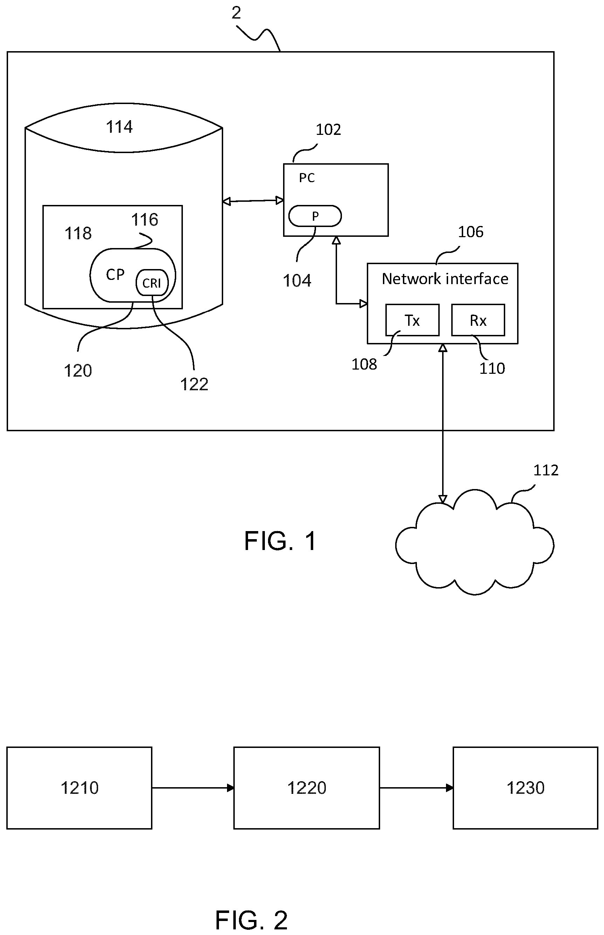

Figure 1 shows a general diagram on an embodiment of the computer device according to the invention.

The computer device shown on Figure 1 as a block diagram of an apparatus 2 (*e.g.,* a network node, connected device, and the like), according to an embodiment. As shown in Figure 1 the apparatus may comprise: processing circuitry (PC) 102, which may include one or more processors (P) 104; a network interface 106 comprising a transmitter (Tx) 108 and a receiver (Rx) 110 for enabling the apparatus to transmit data to and receive data from other computing devices connected to a network 112 (e.g., an Internet Protocol (IP) network) to which network interface 106 is connected; and a local storage unit (a.k.a., "data storage system") 114, which may include one or more non-volatile storage devices and/or one or more volatile storage devices.

In embodiments where PC 102 includes a programmable processor, a computer program product (CPP) 116 may be provided. CPP 116 includes a computer readable medium (CRM) 118 storing a computer program (CP) 120 comprising computer readable instructions (CRI) 122. CRM 118 may be a non-transitory computer readable medium, such as, magnetic media (e.g., a hard disk), optical media, memory devices (e.g., random access memory, flash memory), and the like.

Processors 104 include any means known for performing automated calculus, such as CPUs, GPUs, CPUs and/or GPUs grids, remote calculus grids, specifically configured FPGAs, specifically configured ASICs, specialized chips such as SOCs or NOCs, AI specialized chips, etc.

In an embodiment, data storage 114 may store a superconducting quantum circuit blueprint, element shapes, scattering parameters of simulated elements, transmission lines or lumped elements, and closed network elements data.

In the example described herein, the data storage 114 may be realized in any way suitable, that is by means of a hard disk drive, a solid-state drive, a flash memory, a memory embedded in a processor, a distant storage accessible in the cloud, etc. Data storage 114 may also store any transitory data which may be generated in the course of executing the invention, as well as scattering parameters determined during execution of the method.

In the following the notions of frequency and angular frequency will be designated by the expression frequency for simplicity's sake. The man skilled in the art will readily identify by the context which is relevant.

Figure 2 shows an exemplary schematic of computer program 120.

The computer program (CP) 120 comprises three main modules which work hand-in-hand:
- A tiling module 1210,
- An eigenmode determination module 1220, and
- A quantum correction module 1230.

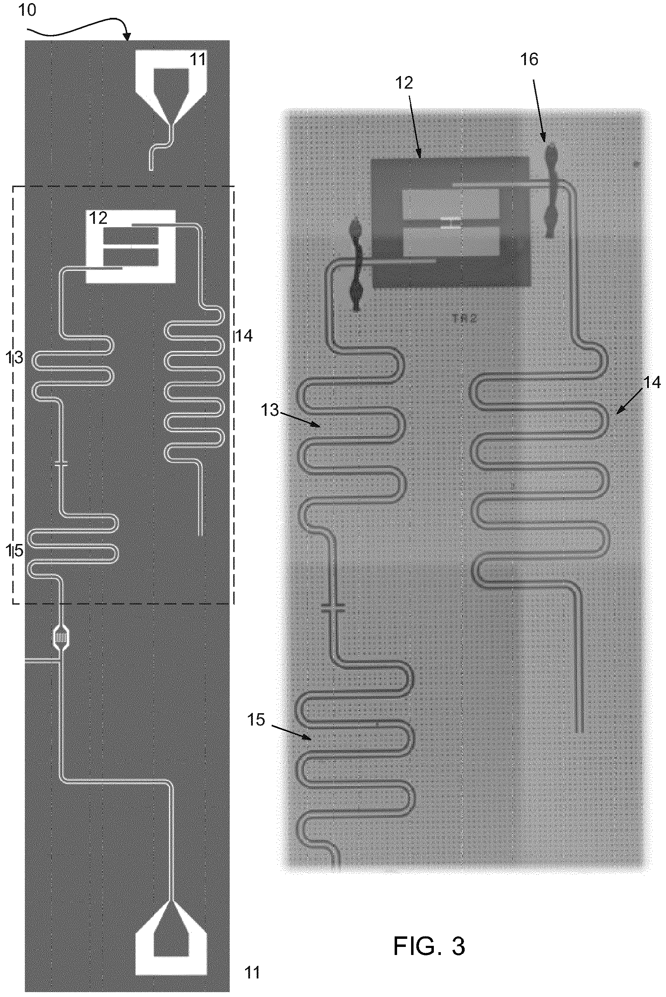

To better understand the invention, Figure 3 shows an exemplary superconducting quantum circuit blueprint 10 (hereinafter " the blueprint 10") which forms the input of the method. The blueprint 10 represents a digital plan of a superconducting quantum circuit to be manufactured. The blueprint 10 is not a high-level or circuit equivalent view or another of abstraction of the superconducting quantum circuit: it is the actual plan which details which part of the substrate will be covered with superconducting metal in order to build the superconducting quantum circuit. In other words, the method aims at providing the physical parameters which characterize the superconducting quantum circuit prior to its manufacturing. It is not a mere simulation, but an actual characterization of the superconducting quantum circuit itself.

On the left of Figure 3, the blueprint shows a superconducting quantum circuit portion connected to another circuit portion as shown by the cut transmission line portion in the bottom left. The superconducting quantum circuit portion comprises two open ended lines 11 for connection to external electronics used to introduce electromagnetic microwaves in the circuit in order to stimulate the resonators, a transmon 12 for hosting a qubit, a readout resonator 13 for accessing the state of the transmon 12, a memory resonator 14, a Purcell filter 15 and the cut transmission line portion connects it to its neighboring circuit portion via an unshown interdigital capacitor. This circuit portion can be used for testing novel qubit architectures with a high fidelity readout protocol for example. In the example shown here, the transmon 12 comprises a Josephson junction between two large, floating (i.e. disconnected from ground) capacitive pads. These pads add a shunt capacitance that decreases the capacitive energy of the junction and thus the anharmonicity. The configuration of this circuit is common, and experiments on a similar device is presented in the article by Heinsoo et al. "Rapid High-fidelity Multiplexed Readout of Superconducting Qubits", Physical Review Applied 10.3 (Sept. 2018). doi: 10.1103/physrevapplied.10.034040. On this figure, the grey background shows the dielectric substrate, whereas the white portion represents the superconducting metal traces used to define the superconducting quantum circuit elements.

On the right of Figure 3, the actual circuit which is manufactured based on the dotted circuit portion of the blueprint is shown. For clarity's sake, the reference numerals of the blueprint have been represented. The only additions are two wirebonds 16 which ensure that all parts of the circuit have the same potential.

As appears from the above example, the superconducting quantum circuit blueprint 10 includes, e.g., a "2D" memory resonator 14. Such a 2D resonator may be formed out of a co-planar waveguide comprising superconducting metal traces and surrounding co-planar superconducting metallic plane deposited on a dielectric substrate. However, as will be understood, certain elements of the blueprint 10 may be "3D". For instance, it is well known in the art to provide a 3D memory resonator, for instance comprised of a cavity extruded from a 3D superconducting metallic component, wherein the 3D memory resonator may be coupled to other elements of the superconducting quantum circuit (both 2D and 3D). Both 2D and 3D components may be connected or coupled by superconducting metallic lines and/or antennas and/or capacitors etc. The man skilled in the art knows how to perform tilings for both 2D and 3D elements, taking into account the teachings herein provided.

The method described herein aims at tiling the blueprint 10 in a series of interconnected elements which can be characterized independently and connected into a closed circuit 20.

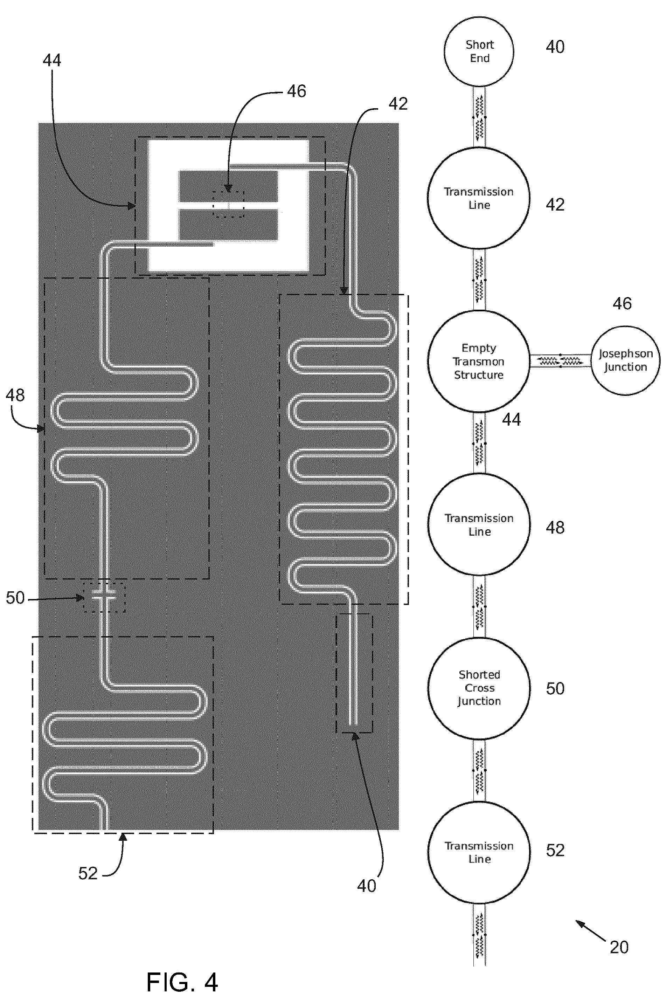

Figure 4 shows an example of such circuit based on the dotted circuit portion of the blueprint of Figure 3. Again, for clarity's sake, the blueprint portion is shown on the left, and the corresponding closed circuit 20 is shown on the right. The reference numerals are shown on both parts so that the correspondence appears more readily.

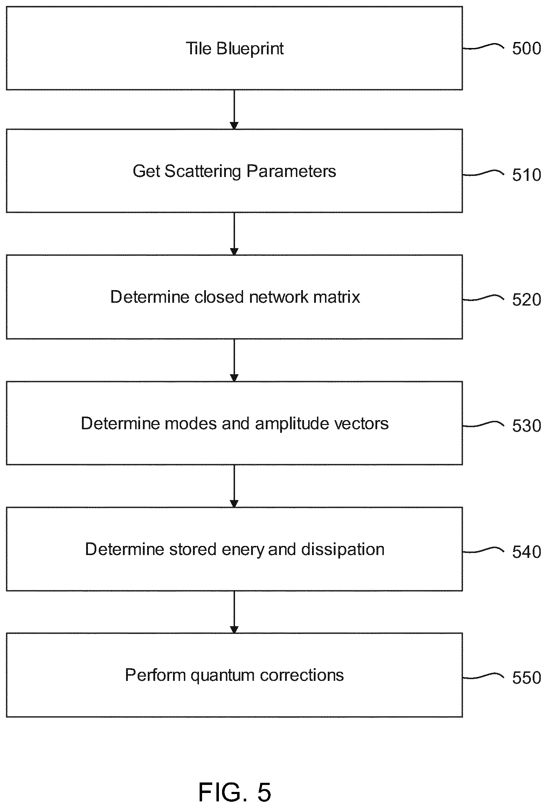

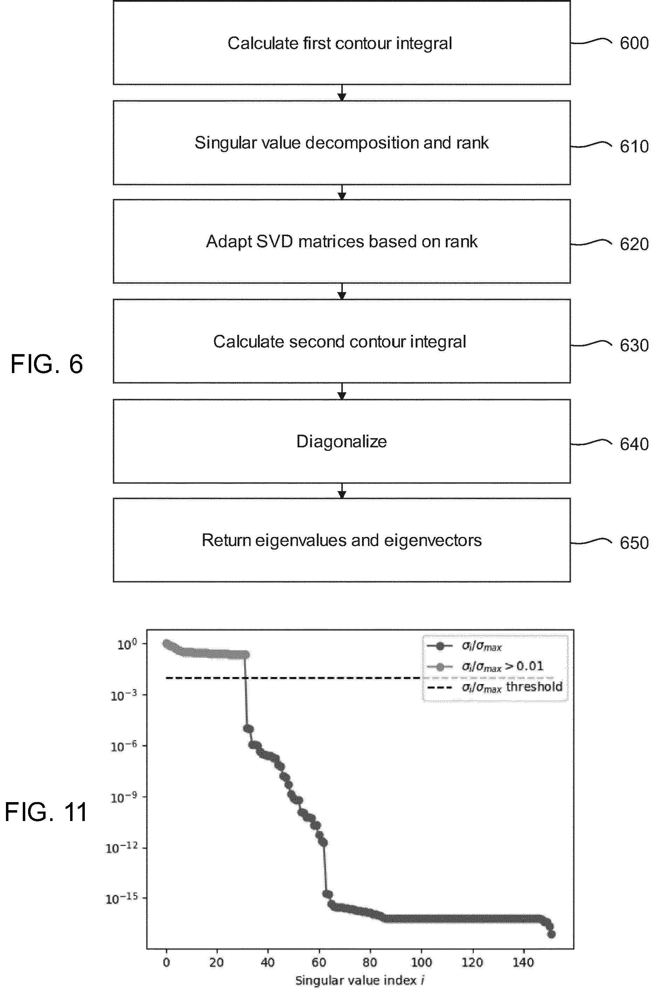

As can be seen on this figure, the closed circuit 20 is defined from the bottom right to the bottom left of the blueprint portion. Hence it comprises a node 40 corresponding to the short end portion, which is followed by a transmission line node which corresponds to the memory resonator 14. The node 42 is connected to a node 44 corresponding to the empty transmon structure - that is the transmon 12 without its Josephson junction - and the node 44 is connected to a node 46 corresponding to the transmon's Josephson junction, and to a transmission line node 48 corresponding to the readout resonator 13. The reason for splitting the transmon 12 into two nodes will be explained in more detail with respect to figures 5 and 6 below. The node 48 is connected to a node 50 corresponding to a shorted cross junction which is itself connected to a transmission line node 52 corresponding to the Purcell filter 15.

As appears, each node can have one or more ports. In the case of node 44, there are three ports whereas node 46 only has a single port. The ports represent the pathways through which the elements corresponding to each node may interact with the elements around him. In other words, the ports represent the inputs and outputs through which a given node can receive or output electromagnetic waves.

Once the closed network 20 is defined by the tiling, each element can be simulated separately. This is very advantageous because it allows to parallelize the processing. Thereafter, the simulated elements are patched together as per the closed network 20 topography in order to determine some of the physical parameters which characterize the superconducting quantum circuit.

Up to this stage, the method may resemble the CSC article, which provides satisfactory results when applied to conventional radiofrequency elements. However, quantum circuits are not conventional, and, even without taking into account their non linearities, the determination of their resonant modes, if the CSC article is applied, requires solving a nonlinear eigenvalue problem for which there is no computationally satisfactory solution. This article teaches using brute force to solve this problem which requires some level of guessing and is devoid of direct method of determining the eigenmodes. As a result there is a high risk of convergence toward wrong solutions.

For this reason, this general overview is also where the comparison with article CSC stops.

Figure 5 shows a block diagram of a method according to an embodiment. In an operation 500, the blueprint 10 is obtained (i.e. recovered from a memory storage, received as an input, or directly drawn in a software by a user) and it is tiled.

According to the invention, the tiling of blueprint 10 is performed so that the resulting elements do not have a self-resonance in the frequency range envisaged for the superconducting quantum circuit. For quantum computing applications, this means that the elements which are the result of the tiling will not showcase a resonant frequency in the 1 GHz to 10 GHz band. This condition is crucial and will appear more clearly below.

The tiling consists in drawing a series of closed contours in the blueprint 10, such that these contours do not overlap, and cover together the entirety of the blueprint 10. This means that the blueprint 10 is the union of all of the elements, which themselves each are a single closed part of the blueprint 10.

This can be done in various ways.

First of all, previous tilings can be reused in order to identify elements in the blueprint 10. Indeed, many elements will tend to be used once they have been validated. Hence, the data storage 114 may comprise a library of elements, which contains elements shapes and may also comprise their corresponding scattering parameters whether simulated or obtained experimentally. This can be particularly useful: once an element has been successfully used in the method, it can be reused for later designs. As a result, as will be discussed below, there are three main types of elements: lumped elements (which can be described by idealized mathematical models), transmission lines, and simulated elements.

As mentioned above, the tiling is not done randomly: it is necessary that the elements resulting from the tiling have no self-resonance in the frequency range of operation of the superconducting quantum system.

This is validated in an operation 510 in which the elements are processed in parallel in order to determine their scattering parameters. The scattering parameters are functions of the frequency which describe the electromagnetic behavior of each element at its ports. The scattering parameters are grouped in a scattering matrix S which size depends on the number of ports of the element.

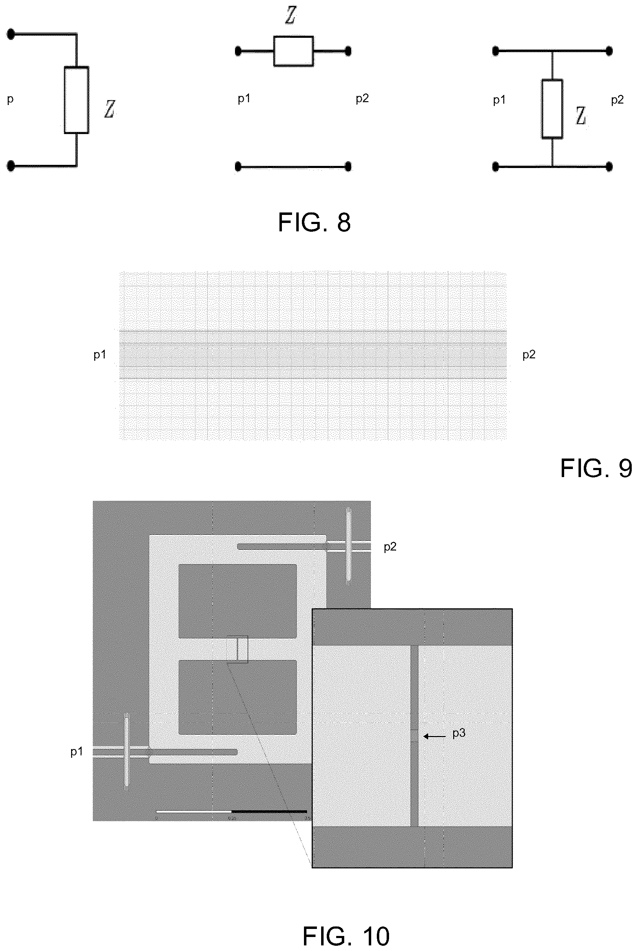

For example, for a single port lumped element as shown on Figure 8, the scattering matrix will be a [1;1] matrix having the formula $S \left(ω\right) = \frac{z \left(ω\right) - {z}_{0}}{z \left(ω\right) + {z}_{0}}$ where *Z*(*ω*) plots the impedance of the element as a function of frequency, and *Z*₀ is the element's port impedance. The port is referenced p, p1 or p2 on this figure.

Similarly, Figure 9 shows a transmission line as it is in a blueprint 10. By high-frequency electromagnetic simulation and fitting of a constant, its scattering matrix can be defined as $S \left(ω\right) = \left[\begin{matrix}0 & {e}^{- γ \left(ω\right) l} \\ {e}^{- γ \left(ω\right) l} & 0\end{matrix}\right]$ with *γ*(*ω*) = *p*₀*ω* + *p*₁ and l the length of the transmission line. The ports are referenced p1 and p2 on this figure.

Figure 10 shows the result of the tiling of a transmon. The transmon is split into it empty structure which has two ports referenced p1 and p2, and the Josephson junction which has a single port referenced p3. For clarity's sake, the Josephson junction portion is zoomed in. As a result, the transmon is simulated as two nodes, one of which is similar to Figure 9, and the other is a Josephson junction with a single node.

In yet another example, a completely arbitrary element having n ports can be simulated, or its scattering parameters be otherwise known, and its scattering matrix will be a [n;n] matrix S which is a function of frequency, with ${S}_{i , j} \left(ω\right) = \frac{{\sum }_{k} {p}_{k} {ω}^{k}}{{\sum }_{k} {q}_{k} {ω}^{k}}$. This type of scattering parameter formulation can be either a direct result of simulation, or be the result of a post-simulation fitting.

Extending the above, complex elements such as ATS (for Asymmetrically Threaded SQUID) or SQUID (for Superconducting Quantum Interference Device) can be pre-characterized in order to accelerate the simulation. For example, an ATS can be modeled as four nodes : an ATS structure node having four ports, two Josephson junction nodes having a single port connected to the ATS structure node, and an array of Josephson junction node having a single port connected to the ATS structure node.

As mentioned above, the scattering parameters and the corresponding element scattering matrix can be obtained from a library of pre-processed elements, or they can be simulated by any of the state of the art software such as Ansys HFSS.

In any case, operation 510 may comprise verifying that the element scattering matrices do not comprise a resonance frequency over the frequency range considered for the superconducting quantum circuit. If such a frequency is encountered, the corresponding element may be split in two in order to remove that resonance. This may be the case for instance with the element of Figure 10 which is a transmon and will be split in two non self-resonant elements. In this case, this also means that the closed circuit 20 has to be amended correspondingly to reflect this change.

Preferably after operation 510, a matrix F reflecting the closed circuit 20 topology may be determined in an operation 520. As a variant, operation 520 may be done in parallel with operation 510. Matrix F will be comprised of values which will either be 0 or 1, and will typically indicate which nodes are connected, and through which port. This matrix F reflects the fact that, because circuit 20 is closed, port *aᵢ* of element *Eₖ* will correspond to port *bⱼ* of element *E*_{*k*-1} to which it is connected. Hence, it appears that the matrix F provides the relationship *Fb* = *a* (Equation 1).

At the same time, if the scattering matrix of each of the element is referenced *Sᵢ*, all electromagnetic microwave input ports are referenced *aᵢ* and all electromagnetic microwave output ports are referenced *bᵢ*, then the scattering matrix of the blueprint 10 can be written as *Sa* = *b* (Equation 2) where $S = \left[\begin{matrix}{S}_{1} & ⋯ & 0 \\ ⋮ & ⋱ & ⋮ \\ 0 & ⋯ & {S}_{n}\end{matrix}\right]$ is a block diagonal matrix of the element scattering matrices.

By plugging Equation 2 into account Equation 1, one can derive that *FSa* = *a*. In other words, the modes of the superconducting quantum circuit which is manufactured based on the blueprint 10 can be obtained by solving the following Equation 3: (*FS*(*ω*) *- I*)*a* = 0, where I is the identity matrix.

The modes of the superconducting quantum circuit will thus be pairs associating a frequency (an eigenfrequency *ω*) and a corresponding amplitude vector (an eigenvector *a*) at the ports in the superconducting quantum circuit.

Generally, this problem is quite a hard one to solve using conventional methods when trying to parallelize the processing, and the reason why the CSC article has not been pursued in practical applications. However, the fact that the tiling is performed in a manner that guarantees scattering parameters which are complex functions of frequency that are holomorphic in a complex domain has enabled the Applicant to change this. This holomorphic nature of the scattering parameters guarantees that the eigenvalue problem is based on a holomorphic matrix function.

Indeed, in an operation 530, Equation 3 is solved by using a holomorphic non-linear eigenvalue solver. Typically, such solvers may be based on Beyn's algorithm using contour integration around the complex frequency domain or on Krylov subspace methods. Other methods may be used.

The result of operation 530 is the set of modes frequencies and corresponding amplitude vectors for the blueprint 10.

Figure 6 shows an exemplary function which realizes operation 530 by using a holomorphic non-linear eigenvalue solver based on Beyn's algorithm.

This approach combines numerical algebra and complex analysis in the specific realm of holomorphic functions.

First of all, let matrix T be a replacement for the matrix of Equation 3. Equation 3 is thus rewritten *T*(*ω*)*a* = 0.

As shown in the article by Beyn "An integral method for solving nonlinear eigenvalue problems", arXiv:1003.1580 [math.NA], the fact that the eigenvalue problem is based on a holomorphic matrix function means that there exists a decomposition such that: *T*⁻¹(*ω*) = *X*(*ωI - Lamba*)⁻¹*Y** *+ N*(*ω*) (Equation 4) where *X* = (*x*₁, ... , *xₘ*) in ${ℂ}^{{N}_{p} , m}$ are the right eigenvectors, and *Y* = (*y*₁, *... , yₘ*) in ${ℂ}^{{N}_{p} , m}$ are the left eigenvectors, *Lambda* = *diag*(*L*₁, ... , *Lₘ*) contains eigenvalues, such that *T*(*Lᵢ*)*xᵢ* = *yᵢ***T*(*Lᵢ*) = 0, *yᵢ***T'*(*Lᵢ*)*xᵢ* = 1, where T' is the dual operator *Nₚ > m*, and *N*(*ω*) is holomorphic.

The contour integration of the product of a holomorphic function *f*(*ω*) with *T*⁻¹(*ω*) around the complex frequency domain reads (Equation 5) $\frac{1}{2 πi} {\int }_{dΩ} f \left(ω\right) {T}^{- 1} \left(ω\right) dω$.

By plugging Equation 4 in Equation 5 can be rewritten $\frac{1}{2 πi} {\int }_{dΩ} f \left(ω\right) X {\left(ωI-Lamba\right)}^{- 1} Y * dω$, as the contour integration of *N*(*ω*) is null.

By taking V and W* out, Equation 5 can further be rewritten $\frac{1}{2 πi} X {\int }_{dΩ} f \left(ω\right) {\left(ωI-Lamba\right)}^{- 1} dωY *$, which, using Cauchy's integral formula ( $\frac{1}{2 πi} {\int }_{γ} \frac{f \left(ω\right)}{z - a} = f \left(a\right)$ when f is holomorphic), can further be rewritten as *Xf*(*Lambda*)*Y**

As a result, $\frac{1}{2 πi} {\sum }_{dΩ} f \left(ω\right) {T}^{- 1} \left(ω\right) dω = Xf \left(Lambda\right) Y *$ (Equation 6).

By choosing *f*(*ω*) = 1, Equation 6 reads $\frac{1}{2 πi} {\int }_{dΩ} {T}^{- 1} \left(ω\right) dω = Xf \left(Lambda\right) Y * = XY * = {X}_{0} {SigmaY}_{0}^{∗}$ (Equation 7) where ${X}_{0} {X}_{0}^{∗} = {Y}_{0}^{∗} {Y}_{0} = I$ and *Sigma* = *diag*(*sigma*₁, ...*sigma_{Nₚ}*).

In other words, by calculating $\frac{1}{2 πi} {\int }_{dΩ} {T}^{- 1} \left(ω\right) dω$, one can obtain Equation 7. Hence, in an operation 600, a first contour integral is calculated.

In an embodiment, this can be done by using the trapezoid rule around the unit circle, which reads $\frac{1}{2 πi} {\int }_{\left|ω\right| = 1} {ω}^{p} {T}^{- 1} \left(rω+c\right) dω = \frac{1}{N} {\sum }_{k = 1}^{N} {e}^{2 πik \left(p+1\right) / N} {T}^{- 1} \left({re}^{2 πi}k/N+c\right)$ where r and c are scaling parameters. For Equation 6, p will be equal to 0. This method is very interesting as it is exponentially converging with N and is highly parallelizable. Using the scaling parameters allows to improve the numerical stability. In this case, the result has to be scaled back after processing.

A cost-saving measure to computing the inverse of T, the product *T*⁻¹*R* can be computed for a random matrix R in ${ℂ}^{{N}_{p} , r}$ where r > m and rank(R)=r by solving the linear system *TG* = *R.*

Once the first contour integral of operation 600 is determined, the result undergoes a singular value decomposition to determine Sigma in an operation 610. The resulting matrix Sigma is ordered by descending sigmaᵢ value, and the ratio of each sigmaᵢ to the first sigma is plotted, i.e. the ratio to the biggest value of Sigma. This allows to determine the number m of eigenvalues in order to bring the nonlinear eigenvalue problem to a linear eigenvalue problem.

The Applicant has determined that in the vast majority of cases, if the tiling is made such that the scattering parameters are complex holomorphic functions of frequency and that no eigenfrequencies lies on the boundary, then the rank m can be determined by making a cutoff on the plot at 0.01. That is, all eigenvalues will have a ratio over 0.01 and the next ones will drop sharply below 0.001, as shown on Figure 11. More generally, the cutoff may vary and be lower to include more eigenmodes, e.g. 0.001 or less.

Now that the rank m has been determined, the matrices *X*₀, *Sigma* and ${Y}_{0}^{∗}$ are modified to adjust to this number of eigenvalues in an operation 620. In order to do so, each of these matrix is brought to m columns as $\hat{{X}_{0}} , \hat{Sigma}$ and $\hat{{Y}_{0}^{∗}}$. Since Y, and Y0 have the same rank m, there is a mapping between these matrices such that $X = \hat{{X}_{0}} M$ and $Y = {M}^{- 1} \hat{Sigma} \hat{{Y}_{0}}$ where M is in ${ℂ}^{m , m}$. Finally, in the case where the product *T*⁻¹*R* is computed instead the full inverse of T, the rows of *Y*₀ are reduced to the r first rows.

Matrix M is determined by realizing a second contour integral in an operation 630, but this time with a function *f*(*ω*) = *ω*.

In this case, Equation 7 is modified to Equation 9 $\frac{1}{2 πi} {\int }_{dΩ} {ωT}^{- 1} \left(ω\right) dω = Xf \left(Lambda\right) Y * = xLambdaY * = \hat{{X}_{0}} {MLambdaM}^{- 1} \hat{Sigma} \hat{{Y}_{0}}$ , and the trapezoid rule around the unit circle can be calculated using p=1 (or again using a probing matrix).

Finally, the result of is diagonalized in an operation 640 by first multiplying on the left by $\hat{{X}_{0}} *$, and on the right by $\hat{Sigma} {\hat{{Y}_{0}}}^{- 1}$ which yields *MLambaM*⁻¹ and by diagonalizing this matrix.

Once M is known, the problem is fully solved as X and Y* can now be calculated in an operation 650, which allows to recover all of the frequencies from Lambda, and the corresponding amplitude vectors. More precisely, the amplitude vectors a are the columns of matrix X, and the amplitude vectors b are the columns of the matrix *S*(*ω*)*a* for each eigenmode. This further allows to determine the corresponding amplitude vectors b for the various resonance frequencies.

After operation 530, the modes and the amplitudes are known everywhere in the system fo)r each mode. This allows to compute the stored energy in each element, as well as the power dissipated by each element.

The stored energy of a mode m in an element e can be calculated from Equation 10 ${W}_{e , m} = \frac{1}{4} {\int }_{V} ϵ {\left|E\right|}^{2} + μ {\left|H\right|}^{2} \partial V = - {ia}^{†} \frac{\partial {S}^{†}}{\partial ω} Sa$

At the same time, the dissipated power for an element can be computed as the difference between the total incoming power, |*a*|², and total outgoing power |*b*|², which can be computed as *a*^{†}(*I* - *S*^{†}*S*)*a*.

The stored energy in each element for each mode and the dissipated energy for each element thereby allow to calculate the quality factor Q and the loss rate κ. More precisely, the quality factor is homogenous to the ratio of stored energy over dissipated power, and the loss rate is homogenous to the ration of the frequency to the quality factor.

Up to this stage, the method has operated as if all of the elements behaved in a purely linear manner, including for Josephson junctions. However they are in fact nonlinear. The frequencies of the resonators are thus expected to shift when the nonlinearity is introduced. This shift will depend on how strong this nonlinearity is and on the state of the oscillator. The transmon mode is participating the most in the nonlinear Josephson junction, and is thus expected to have a the strongest anharmonicity. This anharmonicity is herein called the self-kerr. However, other modes will also be shifted for the same reasons. Their self-kerrs are expected to be low, since they are only participating weakly in the junction. However, they will also be shifted depending on the state of the transmon, and this shift is herein called the cross-kerr. The Hamiltonian for the whole circuit is thus divided in a linear and nonlinear part, where the linear part is fully described by the values of operation 530.

The nonlinear part is herein approximated to the fourth order. In various alternatives, it may be approximated at different orders. This provides for corrections in the form of a Kerr matrix $χ = \left[\begin{matrix}{E}_{j 1} & ⋯ & 0 \\ ⋮ & ⋱ & ⋮ \\ 0 & ⋯ & {E}_{jn}\end{matrix}\right] \left[\begin{matrix}{φ}_{zpf 11}^{4} & ⋯ & {φ}_{zpf 1 m}^{4} \\ ⋮ & ⋱ & ⋮ \\ {φ}_{zpfn 1}^{4} & ⋯ & {φ}_{zpfnm}^{4}\end{matrix}\right]$ where Eⱼᵢ is the Josephson energy of the ji-th Josephson junction and ${φ}_{zpfij}^{4}$ is the zero point fluctuation of the superconducting phase for mode j in the i-th Josephson junction.

In order to determine the Josephson energies, the Joseph junctions inductances are used as inputs and converted Josephson energies according to the equation ${E}_{J} = \frac{{{ϕ}_{0}}^{2}}{{L}_{j} h}$ where *ϕ*₀ is the superconducting flux quantum and L_{J} is the Josephson junction's inductance.

In order to determine the ${φ}_{zpf}^{4}$, the flux has to be determined for each pair of mode and Josephson junction. This is obtained by first normalizing all of the amplitude vectors depending on the stored energy calculated for each element in operation 540, so that all of the amplitude vectors are determined relative to a half photon energy, that is $\frac{ℏ {ω}_{m}}{2}$ where h is the reduced Planck constant and ωₘ is the mode frequency.

Thereafter, ${φ}_{zpfij} = \frac{2 π}{{ϕ}_{0}} \frac{\sqrt{{Z}_{i}}}{{ω}_{j}} \left|{a}_{ij}+{b}_{ij}\right|$ where is the superconducting flux quantum, Zᵢ is the port impedance of Josephson junction i, and ωⱼ is the j-th mode frequency.

As a result, the Kerr matrix can be approximated to a desired order and the parameters of the Hamiltonian of the system can be extracted from this approximation .

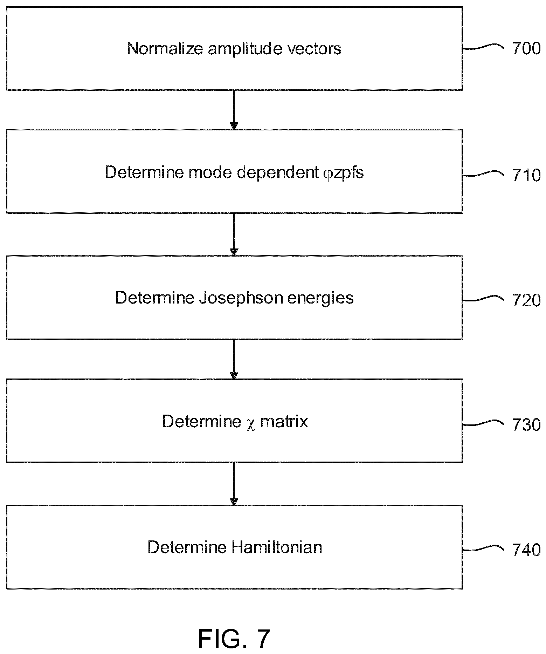

All these steps are represented on an exemplary block diagram shown on Figure 7, in which the amplitude vectors are normalized in an operation 700, which allows to determine the zero point fluctuations in an operation 710. The Josephson energies are determined in an operation 720 or received as inputs, which allows to build the Kerr matrix in an operation 730 and to return the approximated Hamiltonian in an operation 740.

The Applicant's tests have shown that the physical parameters determined using the above method is both extremely fast and more accurate than the existing methods. More precisely, experimentations have shown computing times of about 1 second for solving the eigenmodes compared to close to 7 hours for Ansys HFSS simulations which provided lesser results for 18 modes, excluding the scattering parameters extraction. The Applicant's tests have also shown that the physical parameters determined by the above method are usually less than 1%, e.g. in terms of frequencies, from the physical parameters measured on the superconducting quantum circuit manufactured with the same blueprint, this difference being likely due to the manufacturing process imperfections themselves.

While the above discloses how the blueprint of a superconducting quantum circuit is processed in order to determine the physical parameters of a superconducting quantum circuit manufactured according to this blueprint, it will readily appear that the invention also concerns a method of manufacturing a superconducting quantum circuit in which the superconducting quantum circuit's physical parameters are obtained by the method according to the invention, and in which a superconducting quantum circuit having these physical parameters is manufactured by using the corresponding blueprint. The invention also covers any method of manufacturing a superconducting quantum circuit by simulating its physical parameters and modifying the blueprint based on the results of this simulation any number of times prior to manufacturing the superconducting quantum circuit based on an optimized blueprint.

## Claims

1. A computer-implemented method for determining physical parameters of a superconducting quantum circuit comprising the following operations:
a) obtaining a superconducting quantum circuit blueprint comprising a representation of a physical arrangement of a superconducting metal and a dielectric substrate for forming a 2D or 3D superconducting quantum circuit and a frequency range in the microwave domain,
b) tiling (500) said superconducting quantum circuit blueprint into elements having at least one port for receiving or emitting electromagnetic microwaves, each of said elements being defined as a closed region of said representation and being such that it showcases no self-resonance frequency in said frequency range, and such that each element comprises a port connected to a port of another element, the elements thereby defining a closed network and a corresponding network matrix based on the connections between the ports of respective elements,
c) obtaining (510) scattering parameters for each of said elements, said scattering parameters defining the relationships between all output radiation and all input radiation for each port of each of said elements in the form of a scattering matrix in which the scattering parameters are expressed as a complex function of frequency that is holomorphic in a complex domain,
d) determining (530) mode frequencies and corresponding mode amplitude vectors for a superconducting quantum circuit fabricated using the superconducting quantum circuit blueprint by using a holomorphic non-linear eigenvalue solver to solve the equation (*FS*(*ω*) *- I*)*a* = 0 where F is the network matrix, S is a block diagonal matrix comprising all of the scattering matrices of operation c), I is the identity matrix, *ω* is a complex frequency in the domain where matrix S is holomorphic, and a is a mode amplitude vector.

2. Method according to claim 1, in which operation d) comprises
d1) performing a closed contour integration (600) around the complex frequency domain based on said frequency range for estimating the number of eigenvalues of the equation (*FS*(*ω*) *- I*)*a* = 0 using a rank test,
d2) performing a second closed contour integration (630) around the complex frequency domain based on said frequency range and the number of eigenvalues of operation d1) to identify a corresponding number of pairs each comprising a mode frequency *ωᵢ* and an amplitude vector *aᵢ* which form an eigenvalue and an eigenvector for the matrix *FS*(*ω*)*a*.

3. Method according to claim 2, in which operation d1) comprises:
d11) calculating the contour integration around the complex frequency domain based on said frequency range of (*FS*(*ω*) *- I*)⁻¹,
d12) compute the singular value decomposition of the result of operation d11) and obtain a product *X* _{*} *Sigma* _{*} *Y** where X and Y* are matrices and Sigma is a diagonal matrix,
d13) determining the number of eigenvalues by ordering the values of matrix Sigma and determining the rank of the last diagonal value which is greater than 1/1000 of the diagonal value having the highest value.

4. Method according to claim 3, in which operation d2) comprises:
d21) calculating the contour integration around the complex frequency domain based on said frequency range of *ω*(*FS*(*ω*) *- I*)*a*⁻¹,
d22) multiplying the result of operation d21) on the left by the conjugate transpose of matrix X reduced to a number of columns equal to the number of eigenvalues of operation d1), and on the right by the inverse of matrix Sigma multiplied by matrix Y* reduced to a number of columns equal to the number of eigenvalues of operation d1),
d23) diagonalize the result of operation d22) to obtain a decomposition M = *Lambda* _{*} *M*⁻¹ where Lambda is a diagonal matrix containing the mode frequencies for the superconducting quantum circuit blueprint.

5. Method according to one of the preceding claims, in which operation b) comprises identifying elements in said superconducting quantum circuit blueprint for which scattering parameters are known and tiling based on these elements.

6. Method according to one of the preceding claims, in which operation c) comprises simulating the high-frequency behavior of an element to determine its scattering parameters.

7. Method according to one of the preceding claims, further comprising:
e) calculating (540) the stored energy for each element.

8. Method according to claim 7, further comprising f) determining all zero point fluctuations for Josephson junctions of said superconducting quantum circuit by:
f1) normalizing (700) the mode amplitude vectors by the square of the calculated energy of operation e),
f2) determining the zero point fluctuations (710) for each mode in each Josephson junction, and
f3) determining the Chi matrix (730) based on the energy of each Josephson junction and on the results of operation f2).

9. Method according to one of the preceding claims, further comprising:
g) calculating (540) the dissipated energy for each element.

10. A computer program (120) comprising instructions (122) which, when executed by processing circuitry (102), causes the processing circuitry to carry out the methods of any one of claims 1 to 9.

11. A carrier containing a computer program (120) according to claim 10 wherein the carrier comprises one of an electronic signals, optical signal, radio signal or computer readable storage medium.

12. A computer program product (116) comprising a non-transitory computer readable medium (118) having stored thereon a computer program (120) according to claim 10.

## Patentansprüche

1. Computerimplementiertes Verfahren zur Bestimmung physikalischer Parameter eines supraleitenden Quantenschaltkreises, umfassend die folgenden Operationen:
a) Erhalten eines Entwurfs für einen supraleitenden Quantenschaltkreis, der eine Darstellung einer physikalischen Anordnung eines supraleitenden Metalls und eines dielektrischen Substrats zur Bildung eines 2D- oder 3D-supraleitenden Quantenschaltkreises und eines Frequenzbereichs im Mikrowellenbereich umfasst,
b) Kacheln (500) des Entwurfs für einen supraleitenden Quantenschaltkreis zu Elementen mit mindestens einem Anschluss zum Empfangen oder Aussenden elektromagnetischer Mikrowellen, wobei jedes dieser Elemente als geschlossener Bereich der Darstellung definiert ist und so beschaffen ist, dass es keine Eigenresonanzfrequenz in dem Frequenzbereich aufweist, und wobei jedes Element einen Anschluss umfasst, der mit einem Anschluss eines anderen Elements verbunden ist, wodurch die Elemente ein geschlossenes Netzwerk und eine entsprechende Netzwerkmatrix basierend auf den Verbindungen zwischen den Anschlüssen der jeweiligen Elemente definieren.
c) Erhalten (510) von Streuparametern für jedes der Elemente, wobei die Streuparameter die Beziehungen zwischen der gesamten Ausgangsstrahlung und der gesamten Eingangsstrahlung für jeden Anschluss jedes der Elemente in Form einer Streumatrix definieren, in der die Streuparameter als komplexe Funktion der Frequenz ausgedrückt werden, die in einem komplexen Bereich holomorph ist,
d) Bestimmen (530) von Modenfrequenzen und entsprechenden Modenamplitudenvektoren für einen supraleitenden Quantenschaltkreis, der mithilfe des Entwurfs für einen supraleitenden Quantenschaltkreis hergestellt wurde, durch Verwendung eines holomorphen nichtlinearen Eigenwertlösers zur Lösung der Gleichung (*FS*(*ω*) - *I*)*a* = 0, wobei F die Netzwerkmatrix ist, S eine Blockdiagonalmatrix ist, die alle Streumatrizen der Operation c) umfasst, I die Einheitsmatrix ist, *ω* eine komplexe Frequenz in dem Bereich ist, in dem die Matrix S holomorph ist, und a ein Modenamplitudenvektor ist.

2. Verfahren nach Anspruch 1, wobei Operation d) Folgendes umfasst
d1) Durchführen einer geschlossenen Konturintegration (600) um den komplexen Frequenzbereich basierend auf dem Frequenzbereich zur Schätzung der Anzahl der Eigenwerte der Gleichung (*FS*(*ω*) - *I*)*a* = 0 unter Verwendung eines Rangtests,
d2) Durchführen einer zweiten geschlossenen Konturintegration (630) um den komplexen Frequenzbereich basierend auf dem Frequenzbereich und der Anzahl der Eigenwerte der Operation d1), um eine entsprechende Anzahl von Paaren zu identifizieren, die jeweils eine Modenfrequenz *ωᵢ* und einen Amplitudenvektor *aᵢ* umfassen und einen Eigenwert und einen Eigenvektor für die Matrix *FS*(*ω*)*α*bilden.

3. Verfahren nach Anspruch 2, wobei Operation d1) Folgendes umfasst:
d11) Berechnen der Konturintegration um den komplexen Frequenzbereich basierend auf dem Frequenzbereich von (*FS*(*ω*) - *I*)⁻¹,
d12) Berechnen der Singulärwertzerlegung des Ergebnisses der Operation d11) und Erhalten eines Produkt *X* * *Sigma* * *Y*^{∗}, wobei X und Y* Matrizen sind und Sigma eine Diagonalmatrix ist,
d13) Bestimmen der Anzahl der Eigenwerte durch Sortieren der Werte der Matrix Sigma und Bestimmen des Rangs des letzten Diagonalwerts, der größer ist als 1/1000 des Diagonalwerts mit dem höchsten Wert.

4. Verfahren nach Anspruch 3, wobei Operation d2) Folgendes umfasst:
d21) Berechnen der Konturintegration um den komplexen Frequenzbereich basierend auf dem Frequenzbereich von *ω*(*FS*(*ω*) - *I*)*a*⁻¹,
d22) Multiplizieren des Ergebnisses der Operation d21) links mit der konjugiert Transponierten der Matrix X, deren Spaltenanzahl auf die Anzahl der Eigenwerte der Operation d1) reduziert wurde, und rechts mit der Inversen der Matrix Sigma, multipliziert mit der Matrix Y*, deren Spaltenanzahl auf die Anzahl der Eigenwerte der Operation d1) reduziert wurde,
d23) Diagonalisieren des Ergebnisses der Operation d22), um eine Zerlegung *M* * *Lambda* * *M*⁻¹ zu erhalten, wobei Lambda eine Diagonalmatrix ist, die die Modenfrequenzen für den Entwurf für einen supraleitenden Quantenschaltkreis enthält.

5. Verfahren nach einem der vorstehenden Ansprüche, wobei Operation b) das Identifizieren von Elementen in dem Entwurf für einen supraleitenden Quantenschaltkreis, für die Streuparameter bekannt sind, und das Kacheln basierend auf diesen Elementen umfasst.

6. Verfahren nach einem der vorstehenden Ansprüche, wobei Operation c) das Simulieren des Hochfrequenzverhaltens eines Elements zur Bestimmung seiner Streuparameter umfasst.

7. Verfahren nach einem der vorstehenden Ansprüche, ferner umfassend:
e) Berechnen (540) der gespeicherten Energie für jedes Element.

8. Verfahren nach Anspruch 7, ferner umfassend f) das Bestimmen aller Nullpunktsfluktuationen für Josephson-Übergänge des supraleitenden Quantenschaltkreises durch:
f1) Normalisieren (700) der Modeamplitudenvektoren durch das Quadrat der berechneten Energie von Operation e),
f2) Bestimmen der Nullpunktsfluktuationen (710) für jede Mode in jedem Josephson-Übergang, und
f3) Bestimmen der Chi-Matrix (730) basierend auf der Energie jedes Josephson-Übergangs und auf den Ergebnissen der Operation f2).

9. Verfahren nach einem der vorstehenden Ansprüche, ferner umfassend:
g) Berechnen (540) der dissipierten Energie für jedes Element.

10. Computerprogrammprodukt (120), das Anweisungen (122) umfasst, welche, wenn sie von einer Verarbeitungsschaltung (102) ausgeführt werden, die Verarbeitungsschaltung veranlassen, die Verfahren eines der Ansprüche 1 bis 9 durchzuführen.

11. Träger, der ein Computerprogramm (120) nach Anspruch 10 enthält, wobei der Träger entweder ein elektronisches Signal, ein optisches Signal, ein Funksignal oder ein computerlesbares Speichermedium umfasst.

12. Computerprogrammprodukt (116), das ein nichtflüchtiges computerlesbares Medium (118) umfasst, auf dem ein Computerprogramm (120) nach Anspruch 10 gespeichert ist.

## Revendications

1. Procédé mis en œuvre par ordinateur pour déterminer des paramètres physiques d'un circuit quantique supraconducteur comprenant les opérations suivantes :
a) l'obtention d'un schéma de circuit quantique supraconducteur comprenant une représentation d'un agencement physique d'un métal supraconducteur et d'un substrat diélectrique pour former un circuit quantique supraconducteur 2D ou 3D et une plage de fréquences dans le domaine des micro-ondes,
b) le tuilage (500) dudit schéma de circuit quantique supraconducteur en éléments présentant au moins un port pour recevoir ou à émettre des micro-ondes électromagnétiques, chacun desdits éléments étant défini comme une région fermée de ladite représentation et étant tel qu'il ne présente aucune fréquence d'auto-résonance dans ladite plage de fréquences et tel que chaque élément comprend un port connecté à un port d'un autre élément, les éléments définissant ainsi un réseau fermé et une matrice de réseau correspondante basée sur les connexions entre les ports d'éléments respectifs,
c) l'obtention (510) de paramètres de diffusion pour chacun desdits éléments, lesdits paramètres de diffusion définissant les relations entre tout le rayonnement de sortie et tout le rayonnement d'entrée pour chaque port de chacun desdits éléments sous la forme d'une matrice de diffusion dans laquelle les paramètres de diffusion sont exprimés comme une fonction complexe d'une fréquence qui est holomorphe dans un domaine complexe,
d) la détermination (530) de fréquences de mode et de vecteurs d'amplitude de mode correspondants pour un circuit quantique supraconducteur fabriqué à l'aide du schéma de circuit quantique supraconducteur en utilisant un solveur de valeurs propres non linéaires holomorphes pour résoudre l'équation (*FS*(*ω*) - *I*)*a* = 0 où F est la matrice de réseau, S est une matrice diagonale en blocs comprenant toutes les matrices de diffusion de l'opération c), I est la matrice d'identité, *ω* est une fréquence complexe dans le domaine où la matrice S est holomorphe et a est un vecteur d'amplitude de mode.

2. Procédé selon la revendication 1, dans lequel l'opération d) comprend
d1) la réalisation d'une intégration de contour fermée (600) autour du domaine de fréquence complexe sur la base de ladite plage de fréquences pour estimer le nombre de valeurs propres de l'équation (*FS*(*ω*) - *I*)*a* = 0 en utilisant un test de rang,
d2) la réalisation d'une seconde intégration de contour fermée (630) autour du domaine de fréquence complexe sur la base de ladite plage de fréquences et du nombre de valeurs propres de l'opération d1) pour identifier un nombre correspondant de paires comprenant chacune une fréquence de mode *ωᵢ* et un vecteur d'amplitude *aᵢ* qui forment une valeur propre et un vecteur propre pour la matrice *FS*(*ω*)*a*.

3. Procédé selon la revendication 2, dans lequel l'opération d1) comprend :
d11) le calcul de l'intégration de contour autour du domaine de fréquence complexe sur la base de ladite plage de fréquences de (*FS*(*ω*) - *I*)⁻¹,
d12) le calcul de la décomposition en valeurs singulières du résultat de l'opération d11) et l'obtention d'un produit *X* * *Sigma* * *Y*^{∗} où X et Y* sont des matrices et Sigma est une matrice diagonale,
d13) la détermination du nombre de valeurs propres en ordonnant les valeurs de la matrice Sigma et la détermination du rang de la dernière valeur diagonale qui est supérieure à 1/1000 de la valeur diagonale présentant la valeur la plus élevée.

4. Procédé selon la revendication 3, dans lequel l'opération d2) comprend :
d21) le calcul de l'intégration de contour autour du domaine de fréquence complexe sur la base de ladite plage de fréquences de *ω*(*FS*(*ω*) - *I*)*a*⁻¹,
d22) la multiplication à gauche du résultat de l'opération d21) par la transposée conjuguée de la matrice X réduite à un nombre de colonnes égal au nombre de valeurs propres de l'opération d1) et à droite par l'inverse de la matrice Sigma multipliée par la matrice Y* réduite à un nombre de colonnes égal au nombre de valeurs propres de l'opération d1),
d23) la diagonalisation du résultat de l'opération d22) pour obtenir une décomposition *M* * *Lambda* * *M*⁻¹ où Lambda est une matrice diagonale contenant les fréquences de mode pour le schéma de circuit quantique supraconducteur.

5. Procédé selon l'une des revendications précédentes, dans lequel l'opération b) comprend l'identification d'éléments dans ledit schéma de circuit quantique supraconducteur pour lesquels des paramètres de diffusion sont connus et un tuilage sur la base de ces éléments.

6. Procédé selon l'une des revendications précédentes, dans lequel l'opération c) comprend la simulation du comportement à haute fréquence d'un élément pour déterminer ses paramètres de diffusion.

7. Procédé selon l'une des revendications précédentes, comprenant en outre :
e) le calcul (540) de l'énergie stockée pour chaque élément.

8. Procédé selon la revendication 7, comprenant en outre f) la détermination de toutes les fluctuations de point zéro pour des jonctions Josephson dudit circuit quantique supraconducteur par :
f1) la normalisation (700) des vecteurs d'amplitude de mode par le carré de l'énergie calculée de l'opération e),
f2) la détermination des fluctuations de point zéro (710) pour chaque mode dans chaque jonction Josephson, et
f3) la détermination de la matrice Chi (730) sur la base de l'énergie de chaque jonction Josephson et des résultats de l'opération f2).

9. Procédé selon l'une des revendications précédentes, comprenant en outre :
g) le calcul (540) de l'énergie dissipée pour chaque élément.

10. Produit de programme informatique (120) comprenant des instructions (122) qui, lorsqu'elles sont exécutées par un ensemble de circuits de traitement (102), amènent l'ensemble de circuits de traitement à réaliser les procédés selon l'une quelconque des revendication 1 à 9.

11. Support contenant un programme informatique (120) selon la revendication 10 dans lequel le support comprend un signal parmi un signal électronique, un signal optique, un signal radio ou un support de stockage lisible par ordinateur.

12. Produit de programme informatique (116) comprenant un support non transitoire lisible par ordinateur (118) sur lequel est stocké un programme informatique (120) selon la revendication 10.
